# EUROPEAN PATENT SPECIFICATION

(11) **EP 1 093 220 B1**
(45) Date of publication and mention of the grant of the patent: **29.12.2004**
(21) Application number: 99830653.4
(22) Date of filing: 15.10.1999
(51) Int. Cl.: H03F 1/52, H04R 3/00

(54) **Method of anomalous offset detection and circuit**
Verfahren und Schaltung zur Detektion einer anormalen Off-Set-Spannung
Méthode et circuit pour la détection d'une tension off-set anormale

(43) Date of publication of application: 18.04.2001
(73) Proprietor: STMicroelectronics S.r.l., 20041 Agrate Brianza MI (IT)
(72) Inventor: Ranieri, Danilo, 20099 Sesto S. Giovanni (IT); Brambilla, Davide, 20017 Rho (IT); Botti, Edoardo, 27029 Vigevano (IT); Celant, Luca, 20159 Milano (IT)
(74) Representative: Pellegri, Alberto

(56) References cited:
- EP-A- 0 515 853
- EP-A- 0 661 802
- US-A- 4 034 268
- US-A- 4 150 339
- US-A- 4 301 330
- PATENT ABSTRACTS OF JAPAN vol. 013, no. 378 (E-809), 22 August 1989 (1989-08-22) & JP 01 129515 A (MATSUSHITA ELECTRIC IND CO LTD), 22 May 1989 (1989-05-22)

## Description

The invention relates in general to integrated amplifiers and more in particular to audio amplifiers, and to the techniques for preventing irreversible damages to the speakers and/or other components of the audio system.

### BACKGROUND OF THE INVENTION

An excessive offset on the outputs of amplifying channels coupled to the respective speakers may cause serious damages and even a self-ignition of the speakers.

This problem may be particularly acute in audio systems installed on vehicles, in which a breakdown of de-coupling capacitors installed between the audio processor and the amplifier or an infiltration of moisture may often generate an excessive offset on the output terminals of the relative amplifying channel and therefore on the speaker or speakers connected to them.

Ever more often, manufacturers of these apparatuses demand the presence of automatic detecting devices of anomalous offset conditions on the outputs of the amplifying channels.

A number of techniques have been proposed that are commonly based on the use of large external capacitors for integrating the output signals of an amplifying channel and extract therefrom an average value. On the other hand, because of space saving requisites and limitations of the number of pins of a power packages, the integration of the output signals is performed in common on all amplifying channels and this arrangement may miss the objective if for example two channels develop an anomalous offset of opposite sign simultaneously.

There is a need and/or usefulness for a more effective method of detecting anomalous offset conditions which, besides precluding erroneous detections and having a high speed of detection, implemented with circuit means that may be easily and wholly integrated with a reduced silicon area requisite.

### SUMMARY OF THE INVENTION

The present invention provides a new method and an implementing circuit effectively fulfilling the above noted requisites.

The method of the invention consists in:
- establishing an interval or phase in the order of tens of milliseconds in which to measure the offset by applying to an input of an offset detection circuit a pulse of the same duration of the established interval with a certain frequency of repetition;
- detecting the rising edge of the input pulse by setting a bistable circuit whose output generates a logic signal signalling the existence of an offset outside a certain window;
- resetting said bistable circuit upon the occurrence, after said initial set, and for the entire duration of said detection period, of a signal amplitude within said window on the output nodes of the amplifying channel.

The detection period, that is the pulse duration, may have a value equal to the period of an audio band signal of a frequency generally not less than 10Hz. The detection interval may have a fixed or variable duration established by the microprocessor that controls the audio system, generally comprised between 50 and 100 milliseconds.

In practice the bistable circuit, commonly an SR latch, is set by a rising edge detector at the beginning of each detection phase of the offset, and is eventually reset during the detection phase if no anomalies are detected.

Once maximum limit thresholds negative and positive of the offset are fixed, in absence of an audio signal, during a phase in which the channel is in a play mode, any offset that may be present on the output nodes of the amplifying channel is compared with the fixed thresholds (positive and negative) and if found to exceed any of them at any time during the detection period, an output logic signal indicating an abnormally large offset is generated.

Of course, every time the amplifier is turned on, with the audio amplifier muted, and therefore in absence of input signals, the system's microprocessor may test the offset condition on the outputs of the various amplifying channels.

When the audio processor in a play mode, there will be an audio signal fed to the input and is the audio signal is summed to the offset on the output terminals of the amplifying channel.

In this case, the detection of an anomalous offset condition would require to hit a portion of the audio signal that has a sufficiently low amplitude such that during a whole detection interval, the sum of the signals on the output terminals (audio signal plus the offset) remains outside the window of tolerable values. Indeed, the sum signal could remain inside the comparison notwithstanding an excessively large offset if opposite sign of the audio signal and the system would fail to detect the abnormal offset condition.

However, it has been proved that for an interval of about 50-100 milliseconds, it is statistically extremely unlikely a failure of the detection system because the band width of the audio signal is generally comprised between 20Hz and 20KHz and therefore the audio signal crosses the zero level many times during a whole detection interval.

A particularly advantageous aspect of the method of the invention is its speed and effectiveness in detecting an anomalous condition as the offset increases towards dangerous levels.

Moreover, it is always possible, with the method of the invention, to command a continuous offset detection, by simply imposing a frequency of repetition equivalent to the duration of the detection phase, thus allowing for a continuous check of the offset.

Naturally, both the detection period and the repeating frequency may be varied by the system's microprocessor.

The rupture of a coupling capacitor is one of the most dangerous causes of a suddenly excessive offset because a DC signal is directly applied to the input of the audio amplifier. For example, by considering the DC output voltage of an audio processor supplied at 8V=2*V(aP), and V(Csvr) equal to the ground reference potential of the audio amplifier, in case of rupture of a coupling capacitor, to the input of the audio amplifier is applied a voltage equal to V(Csvr)-V(aP)≈7-4≈3V.

Assuming 3V*26db=90V, the output will be completely clipped (Voffset>12V). In such a case, the method of the invention after a first detection phase will signal the anomaly, in practice denouncing the existence of a rupture.

According to this invention, an effective detecting circuit of the offset on the output nodes of an amplifying channel may be composed of:
- at least a bistable circuit having a reset input, a set input and an output coupled to a first input of a NOR gate having a second input coupled to the input node of a timing signal, outputting a logic signal representative of the result of an offset detection phase;
- at least a rising edge detector having an input coupled to a source of said timing signal and an output coupled to the set input of said bistable circuit;
- a window comparator, having inputs coupled to the output nodes, of the amplifying channel and an output coupled to a first input of a NAND gate, a second input of which is coupled to the source of the timing signal and an output coupled to the reset input of said bistable circuit.

### BRIEF DESCRIPTION OF THE DRAWINGS

**Figure 1** is a high level diagram of the circuit of the invention.
**Figure 2** is a more detailed circuit diagram of an embodiment of the functional block diagram of figure 1.

### DESCRIPTION OF SEVERAL EMBODIMENTS OF THE INVENTION

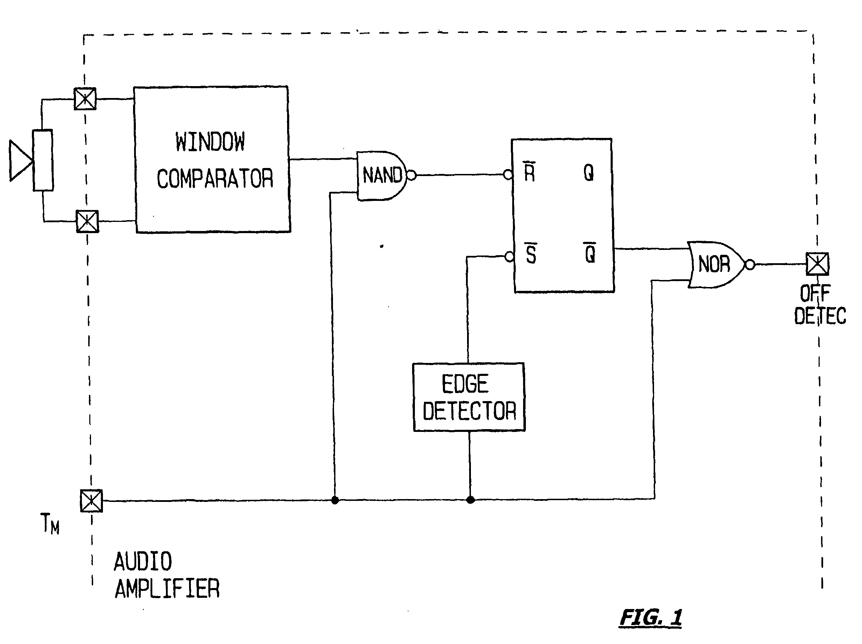

The block diagram shown in figure 1 depicts the circuit of the invention for detecting the offset, as it may be implemented in any conventional integrated device whose details are not shown in the figure.

Of course, the scheme concerns a single amplifying channel and, if the integrated device comprises several amplifying channels, the circuit of the invention may be replicated for each amplifying channel as needed.

Essentially, at detection phase of a prefixed duration equivalent to the period of a signal in the audio band of frequency not lower than 10 Hz, and generally comprised between 50 and 100 milliseconds, a bistable circuit, typically an SR latch, that is set by an EDGE DETECTOR of a timing pulse Tm is reset whenever the signal amplitude on the output nodes of the amplifying channel, which in the figure is connected to a speaker, is found to be inside a certain window of tolerable values, symmetric about the zero level, as determined by a conventional WINDOW COMPARATOR.

If this does not occurs, the output signal OFF DETECT switches, indicating that an anomalous offset has been detected.

The duration of the timing pulse Tm that fixes the detection interval is sufficient to substantially exclude spurious signalling of an anomaly during the normal functioning of the audio amplifier, because during the Tm interval, the audio signal will almost certainly cross the zero level and thus the output level will be checked for absence of an anomalous offset condition.

Of course, such a problem of reliability of the detection will no longer exist in absence of an audio signal.

A particularly effective characteristic of the system of the invention is that its ability to detect an anomalous (excessive) offset condition is further enhanced in coincidence with particularly dangerous conditions for the integrity of the audio system.

Indeed, the higher the offset in respect to the fixed symmetric thresholds, the more the system tolerates it as long as in presence of a relatively higher audio signal amplitude for an enhanced ability to correctly discriminate a real anomaly.

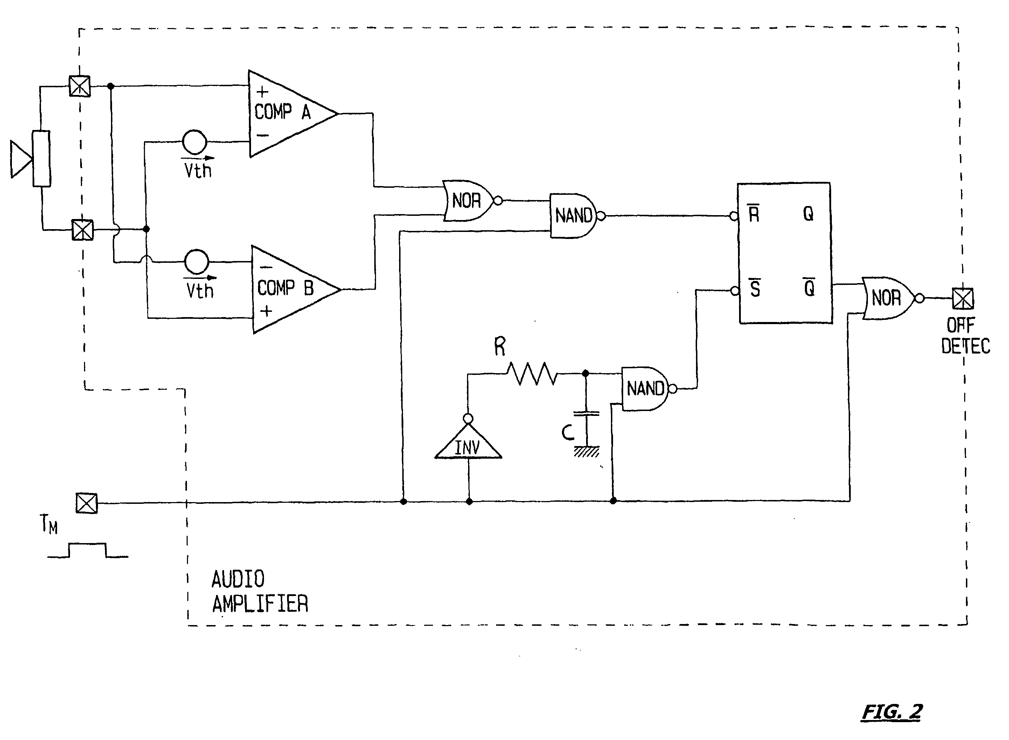

Figure 2 shows a circuit of a feasible detection of the system of the invention.

The window comparator may be constituted conventionally by a pair of comparators with the same prefixed threshold Vth, namely CompA and CompB, inverting inputs (-) and noninverting inputs (+) of which are cross-coupled to the two output nodes of the amplifying channel (connected to the respective a speaker) as shown in the figure. The outputs of the two comparators are combined by the NOR gate producing a logic signal that represents the result of the comparison.

The EDGE DETECTOR may be realized as illustrated and may be composed of the inverter INV, the RC network and the NAND gate.

In general, the system may require two pins, one to feed the timing signal Tm and the other to make available the output logic signal OFF DETECT signalling the offset condition. Alternatively, both the input signal Tm and the output signal OFF DETECT may be conveyed via a digital bus protocol (for example a I2Cbus).

Commonly, the OFF DETECT signal produced by the detection system of the invention will be read by the microprocessor that controls the entire audio system and which may consequently execute appropriate commands, for example through a I2Cbus control bus.

If an excessive offset is signalled on a channel, the microprocessor may for example command the "muting" of that channel.

The system's microprocessor may impose a certain detection interval by varying the duration of the Tm pulse and/or the frequency thereof, according to a specific control software. Of course, the microprocessor may also adopt certain criteria in order to interpret the information derived from the OFF DETECT signal. For example, it may decide that a certain audio channel presents an anomalous offset if the OFF DETECT signal is rised for three times in succession upon the performance as many of detecting phases.

The system of the invention requires the integration of comparators and of conventional digital components, all relatively easy to integrate and requiring a limited silicon space.

By contrast, the known solutions require complex digital or analog filters for extracting a DC component (i.e. below about 20Hz) from the output signal of the channel. In order to filter and read the DC component of the outputs signals numerous pins are normally required.

By comparison, the solution of the present invention is highly reliable and can be implemented with exceptionally low cost.

## Claims

1. A method of assessing the offset on the output nodes of an amplifying channel by generating a logic signal signalling the existence of an offset of a level exceeding a window of permitted levels symmetric about the zero level, defined by a negative limit value and by a positive limit value, consisting in
- establishing an interval or phase of detection by applying to an input of a detection circuit a timing pulse with a certain frequency;
- sensing the rising edge of said timing pulse and setting a bistable circuit;
- comparing the signal on the output nodes of the amplifiers channel with said window of permitted values;
- resetting said bistable circuit upon the occurrence, after said initial setting, of an output signal amplitude within said window of permitted values;
- failure of said bistable circuit to reset before the end of the detection phase signalling an excessive offset.

2. The method of claim 1, wherein the duration of the offset detection phase is equivalent to the period of an audio band signal of frequency not lower than 10Hz.

3. The method of claim 2, wherein said period is between 50 and 100 milliseconds.

4. A circuit for assessing the offset on the output nodes of an amplifying channel comprising:
- at least a bistable circuit having a reset input, a set input and an output coupled to a first input of a NOR gate having a second input coupled to a source of a timing signal, outputting a logic signal representative of the result of an offset detection phase;
- at least a rising edge detector having an input coupled to the source of said timing signal and an output coupled to the set input of said bistable circuit;
- a window comparator, having inputs coupled to the output nodes of the amplifying channel and an output coupled to a first input of a NAND gate, a second input of which is coupled to the source of said timing signal and whose output is coupled to the reset input of said bistable circuit.

5. The circuit of claim 4, wherein said window comparator is constituted by a pair of comparators of identical thresholds, the inverting inputs and noninverting inputs of which are cross-coupled to the output nodes of the amplifying channel, and an output NOR gate having two inputs respectively coupled to the outputs of said comparators.

## Patentansprüche

1. Verfahren zur Bewertung des Offsets an den Ausgangsknoten eines Verstärkungskanals durch Erzeugung eines logischen Signals, welches das Vorhandensein eines Offsets mit einem Pegel signalisiert, der ein Fenster zulässiger Pegel überschreitet, das um den Nullpegel symmetrisch ist, das durch einen negativen Grenzwert und durch einen positiven Grenzwert definiert wird, das die Schritte aufweist:
- Herstellen eines Intervalls oder einer Detektionsphase, indem an einen Eingang einer Detektionsschaltung ein Zeitsteuerimpuls mit einer bestimmten Frequenz angelegt wird;
- Abtasten der Anstiegsflanke des Zeitsteuerimpulses und Setzen einer bistabilen Schaltung;
- Vergleichen des Signals an den Ausgangsknoten des Verstärkungskanals mit dem Fenster zulässiger Werte;
- Rücksetzen der bistabilen Schaltung beim Auftreten einer Ausgangssignalamplitude innerhalb des Fensters zulässiger Werte nach dem anfänglichen Setzen;
- wobei ein Nichtrücksetzen der bistabilen Schaltung vor dem Ende der Detektionsphase einen übermäßigen Offset signalisiert.

2. Verfahren nach Anspruch 1, wobei die Dauer der Offset-Detektionsphase zur Periode eines Niederfrequenzbandsignals mit einer Frequenz von nicht weniger als 10 Hz äquivalent ist.

3. Verfahren nach Anspruch 2, wobei die Periode zwischen 50 und 100 Millisekunden liegt.

4. Schaltung zur Bewertung des Offsets an den Ausgangsknoten eines Verstärkungskanals, die aufweist:
- mindestens eine bistabile Schaltung, die einen Rücksetzeingang, einen Setzeingang und einen Ausgang aufweist, der mit einem ersten Eingang eines NOR-Glieds gekoppelt ist, dessen zweiter Eingang mit einer Quelle eines Zeitsteuersignals gekoppelt ist, das ein logisches Signal ausgibt, das für das Ergebnis einer Offset-Detektionsphase repräsentativ ist;
- mindestens einen Anstiegsflankendetektor, von dem ein Eingang mit der Quelle des Zeitsteuersignals gekoppelt ist und ein Ausgang mit dem Setzeingang der bistabilen Schaltung gekoppelt ist;
- einen Fensterkomparator, dessen Eingänge mit den Ausgangsknoten des Verstärkungskanals gekoppelt sind und dessen Ausgang mit einem ersten Eingang eines NAND- Glieds gekoppelt ist, dessen zweiter Eingang mit der Quelle des Zeitsteuersignals gekoppelt ist und dessen Ausgang mit dem Rücksetzeingang der bistabilen Schaltung gekoppelt ist.

5. Schaltung nach Anspruch 4, wobei der Fensterkomparator aus einem Paar Komparatoren mit identischen Schwellen, deren invertierende Eingänge und nichtinvertierende Eingänge mit den Ausgangsknoten des Verstärkungskanals kreuzgekoppelt sind, und einem Ausgangs-NOR-Glied besteht, das zwei Eingänge aufweist, die jeweils mit den Ausgängen der Komparatoren gekoppelt sind.

## Revendications

1. Procédé de détermination de l'offset sur une sortie d'un canal d'amplification en produisant un signal logique signalant l'existence d'un offset d'un niveau dépassant une fenêtre de niveaux permis symétrique par rapport au niveau zéro, définie par une valeur limite négative et une valeur limite positive, consistant à :
établir un intervalle ou phase de détection en appliquant à une entrée d'un circuit de détection une impulsion de temporisation à une certaine fréquence ;
détecter le front montant de l'impulsion de temporisation et mettre à un un circuit bistable ;
comparer le signal sur les noeuds de sortie du canal amplificateur à la fenêtre de valeurs permises ;
remettre à zéro le circuit bistable lors de l'apparition, après la mise à un initiale, d'une amplitude de signal de sortie à l'intérieur de la fenêtre de valeurs permises ;
une non remise à zéro du circuit bistable avant la fin de la phase de détection signalant un offset excessif.

2. Procédé selon la revendication 1, dans lequel la durée de la phase de détection d'offset est équivalente à la période d'un signal de bande audio de fréquence non inférieure à 10 Hz.

3. Procédé selon la revendication 2, dans lequel la période est comprise entre 50 et 100 millisecondes.

4. Circuit pour déterminer le décalage sur les noeuds de sortie d'un canal amplificateur comprenant :
au moins un circuit bistable ayant une entrée de remise à zéro, une entrée de mise à un et une sortie couplée à une première entrée d'une porte NON OU ayant une seconde entrée couplée à une source de signal de temporisation, fournissant un signal logique représentatif du résultat de la phase de détection d'offset ;
au moins une détecteur de front montant ayant une entrée couplée à la source du signal de synchronisation à une sortie couplée à l'entrée de remise à un du circuit bistable ;
un comparateur à fenêtre ayant des entrées couplées aux noeuds de sortie du canal d'amplification et une sortie couplée à une première entrée d'une porte NON ET, dont une seconde entrée est couplée à la source de signal de temporisation et dont la sortie est couplée à l'entrée de remise à zéro du circuit bistable.

5. Circuit selon la revendication 4, dans lequel le comparateur à fenêtre est constitué de deux comparateurs à seuils identiques, dont les entrées inverseuses et non inverseuses sont couplées de façon croisée aux noeuds de sortie du canal d'amplification et une porte NON OU de sortie ayant deux entrées respectivement couplées aux sorties des comparateurs.
